# EUROPEAN PATENT SPECIFICATION

(11) **EP 4 284 201 B1**
(45) Date of publication and mention of the grant of the patent: **15.01.2025**
(21) Application number: 22705369.1
(22) Date of filing: 27.01.2022
(51) Int. Cl.: A24F 40/50, H03K 17/687, A24F 40/465, H05B 6/10, H05B 6/06

(54) **INDUCTIVE HEATING ARRANGEMENT FOR HEATING AEROSOL-FORMING SUBSTRATES**
INDUKTIVE ERWÄRMUNGSANORDNUNG ZUM ERWÄRMEN VON AEROSOLBILDENDEN SUBSTRATEN
AGENCEMENT DE CHAUFFAGE PAR INDUCTION POUR CHAUFFER DES SUBSTRATS DE FORMATION D'AÉROSOL

(30) Priority: 28.01.2021 EP 21153930
(43) Date of publication of application: 06.12.2023
(73) Proprietor: Philip Morris Products S.A., 2000 Neuchâtel (CH)
(72) Inventor: COURBAT, Jerome Christian, 2000 Neuchâtel (CH); MIRONOV, Oleg, 2000 Neuchâtel (CH); STURA, Enrico, 2000 Neuchâtel (CH); MONNEY, Patrick Philippe, 2000 Neuchâtel (CH)
(74) Representative: Grünecker Patent- und Rechtsanwälte PartG mbB
(86) International application number: PCT/EP2022/051851
(87) International publication number: WO 2022/162046

(56) References cited:
- WO-A1-2018/096000
- WO-A2-2018/178114
- US-A1- 2010 259 179
- MINDUBAEV EDUARD A ET AL: "Frequency Tuning Feedback System for an Inductive Powering Unit with Class E Power Amplifier", 2019 IEEE CONFERENCE OF RUSSIAN YOUNG RESEARCHERS IN ELECTRICAL AND ELECTRONIC ENGINEERING (EICONRUS), IEEE, 28 January 2019 (2019-01-28), pages 2321 - 2323, XP033525363, DOI: 10.1109/EICONRUS.2019.8657172

## Description

The present invention relates to an inductive heating arrangement for heating of an aerosol-forming substrate. The invention further relates to an aerosol-generating device and an aerosol-generating system comprising such an inductive heating arrangement. Furthermore, the invention relates to a method and an apparatus for calibrating such a heating arrangement.

Inductive heating arrangements used for generating inhalable aerosols by inductively heating aerosol-forming substrates capable to form inhalable aerosols are generally known from prior art. In general, such heating arrangements may comprise an induction source for inductively heating a susceptor arrangement which is in thermal proximity or direct physical contact with the substrate to be heated. The induction source is configured for generating an alternating magnetic field which induces at least one of heat generating eddy currents or hysteresis losses in the susceptor arrangement. While the induction source typically is part of an aerosol-generating device, the susceptor arrangement may be either part of the device or part of an aerosol-generating article which comprises the substrate to be heated and is configured to be received in an aerosol-generating device including the induction source.

For generating the alternating magnetic field, the heating arrangement may comprise a DC/AC inverter including a resonant switching power amplifier. The amplifier comprises a switching device and a resonating LC load network comprising a capacitor and an inductor, wherein the inductor generates the alternating magnetic field during operation. While such resonant switching inverters have proven advantageous with respect to a rapid generation of the required heat in the susceptor, the output power may be subject to variations with respect to a nominal target output power. In principle, the variation in the output power can be limited by using electronic components with tight tolerances. However, such components are expensive or place high demands on their manufacture.

Therefore, it would be desirable to have an inductive heating arrangement for heating an aerosol-forming substrate as well as an aerosol-generating device and system comprising such a heating arrangement with the advantages of prior art solutions, whilst mitigating their disadvantages. In particular, it would be desirable to have an inductive heating arrangement for heating an aerosol-forming substrate as well as an aerosol-generating device and system comprising such a heating arrangement which allows less strict requirements to be placed on the component tolerances, while still keeping performance variations within acceptable limits.
WO 2018/096000 A1 discloses an inductive heating device configured to receive an aerosol-generating article comprising an aerosol-forming substrate and a susceptor, the inductive heating device being configured to heat the susceptor when the aerosol-generating article is received by the inductive heating device.
WO 2018/178114 A2 discloses a method and apparatus for use with an RLC resonance circuit for inductive heating of a susceptor of an aerosol-generating device.
US 2010/0259179 A1 discloses an electronic dimming device using a pulse width modulation (PWM) generator receiving a clock frequency from a very high-resolution tunable oscillator.
MINDUBAEV EDUARDA ET AL, "Frequency Tuning Feedback System for an Inductive Powering Unit with Class E Power Amplifier", 2019 IEEE CONFERENCE OF RUSSIAN YOUNG RESEARCHERS IN ELECTRICAL AND ELECTRONIC ENGINEERING (EICONRUS), IEEE, pages 2321 - 2323, discloses a system for an inductive powering unit with a class E power amplifier.

According to the present invention, there is provided an inductive heating arrangement for heating of an aerosol-forming substrate. The heating arrangement comprises a DC power source and a power supply electronics comprising a DC/AC inverter connected to the DC power source. The DC/AC inverter comprises a resonant switching power amplifier with at least one transistor switch, at least one transistor switch driver circuit associated with the transistor switch and an LC load network. The LC load network comprises at least one capacitor and at least one inductor, wherein the inductor is configured to generate an alternating magnetic field during operation of the heating arrangement for inductively heating the aerosol-forming substrate via a susceptor arrangement. The transistor switch driver circuit comprises a tunable oscillator configured to output a switching signal to the transistor switch having a tunable switching frequency.

According to the invention, it has been found that the variations in the output power observed with prior art devices are due to a deviation of the actual resonance curve from the nominal resonance curve of the LC load network. As a consequence, the switching frequency of the switching device, which so far is chosen with respect to a desired working point on the nominal resonance curve, effectively is at a different working point on the actual resonance curve which in turn is associated with an output power different from the desired target value. In particular, it has been found that a tolerance of more than ±1 percent of the nominal inductance of the inductor and the nominal capacitance of the capacitor of the LC load network may result in a variation of more than ±17 percent of the nominal target output power of the heating arrangement. Such variations in the output power over different devices typically are not acceptable. Instead of using capacitors and inductors with tighter tolerances, the present invention suggests to use a transistor switch driver circuit comprising a tunable oscillator which is configured to output a switching signal to the transistor switch having a tunable switching frequency. This allows for tuning the switching frequency of the switching signal and thus for shifting the effective working point on the actual resonance curve of the LC load network to a position which is associated with a desired target output power. For example, the switching frequency of the switching signal may be tuned to a desired range around the actual resonance frequency of the LC load network. Likewise, the switching frequency of the switching signal may be tuned to a desired range offset to the actual resonance frequency of the LC load network. In other words, by tuning the switching frequency the resonant switching power amplifier can be tuned to the proper working point on the actual resonance curve which is associated with an acceptably small range around the actually desired target output power. As a result, the variation of the output power can be significantly limited, while at the same time the requirements for the tolerances of the capacitors and inductors can be set lower. For example, instead of using capacitors and inductors having a tolerance of ±1 percent or less of the nominal capacitance and inductance, respectively, the tunable oscillator allows for using a capacitor with a capacitance tolerance of ±2 percent or more and an inductor with an inductance tolerance of even ±5 percent or more.

In particular, a tolerance of a capacitance of the capacitor of the LC load network may be in a range between ±2 percent and ±4 percent of a nominal capacitance value of the capacitor. Likewise, a tolerance of an inductance of the inductor of the LC load network may be in a range between ± 3 percent and ±7 percent, in particular between ± 4 percent and ±6 percent, preferably of ±5 percent a nominal inductance value of the inductor. As used herein, the term "tolerance" refers to the permissible limit or limits of variation in a physical property (deviation from a nominal value); here, the capacitance of the capacitor and the inductance of the inductor, respectively. Using capacitors and inductors with tolerances in these ranges results in a significant reduction of costs, because the manufacture of these components is less demanding

In general, the inductive heating arrangement may be configured to generate a high-frequency alternating magnetic field. As referred to herein, the high-frequency alternating magnetic field may be in the range between 500 kHz (kilo-Hertz) to 30 MHz (Mega-Hertz), in particular between 5 MHz (Mega-Hertz) to 15 MHz (Mega-Hertz), preferably between 5 MHz (Mega-Hertz) and 10 MHz (Mega-Hertz).

Preferably, the switching frequency is tunable in a range of ±20 percent, in particular ±10 percent, preferably ±5 percent around a center frequency. In general, the center frequency may be any frequency within the frequency ranges of the alternating magnetic field defined above. Preferably, the center frequency is in a range between 6.5 MHz (Mega-Hertz) and 7.1 MHz (Mega-Hertz), in particular between 6.7 MHz (Mega-Hertz) and 6.9 MHz (Mega-Hertz), for example at 6.78 MHz (Mega-Hertz). Likewise, the switching frequency may be tunable in a range between 5.4 MHz (Mega-Hertz) and 8 MHz (Mega-Hertz), in particular between 6.0 MHz (Mega-Hertz) and 7.5 MHz (Mega-Hertz), preferably between 6.4 MHz (Mega-Hertz) and 7.2 MHz (Mega-Hertz). On the one hand, these tuning ranges may be sufficiently large to tune the switching power amplifier to its desired working point and, thus, to limit the variation of the output power. On the other hand, these tuning ranges are small enough to keep the costs for the tunable oscillator low, while still allowing the switching frequency to be precisely tuned and kept stable once set to a specific value.

Preferably, the tunable oscillator is a MEMS-based (micro-electro-mechanical system) tunable oscillator, a voltage-controlled oscillator (VCO) or a Colpitts oscillator.

As used herein, the term "switching power amplifier" refers to an electronic amplifier in which comprises one or more amplifying transistors operated as electronic switches, and not as linear gain devices as in other amplifiers. The switching power amplifier may be one of a class-C power amplifier, a class-D power amplifier and a class-E power amplifier.

A class-D amplifier is an electronic amplifier comprising two transistor switches and two transistor switch driver circuits for switching the two transistor switches on and off. The transistors switches are controlled at high frequency in a manner so as to make sure that one of the two transistor switches has been switched off at the time the other of the two transistor switches is switched on.

In contrast, a class-E power amplifier includes a single transistor switch only. Class-E power amplifiers are known for minimum power dissipation in the transistor switch during the switching transitions. The circuit obtains high efficiency by only operating the transistor switch at points of zero current (on to off switching) or zero voltage (off to on switching) which minimizes power losses in the switch. The general operating principle of class-E power amplifiers is known and described in detail, for example, in the article "Class-E RF Power Amplifiers", Nathan O. Sokal, published in the bimonthly magazine QEX, edition January/February 2001, pages 9-20, of the American Radio Relay League (ARRL), Newington, CT, USA. In general, a class-E power amplifier may include a transistor switch and an LC load network configured to operate at low ohmic load, wherein the LC load network comprises a series connection of a capacitor and an inductor. In particular, the LC load network may comprise a series connection of the capacitor and the inductor. In addition, the LC load network comprises a shunt capacitor. Preferably, the class-E power amplifier is a single-ended first order class-E power amplifier having a single transistor switch only.

The at least one transistor switch of the switching power amplifier can be any type of transistor and may be embodied as a bipolar-junction transistor (BJT). More preferably, however, the transistor switch is embodied as a field effect transistor (FET) such as a metal-oxide-semiconductor field effect transistor (MOSFET) or a metal-semiconductor field effect transistor (MESFET).

Due to the very low number of components the volume of the power supply electronics can be kept extremely small. This extremely small volume of the power supply electronics is possible due to the inductor of the LC load network being directly used as the inductor for the inductive coupling to the susceptor arrangement. The small volume further allows the overall dimensions of the entire inductive heating arrangement to be kept small.

The DC power source generally may comprise any suitable DC power source configured to provide a DC supply voltage and a DC supply current to the power supply electronics. Preferably, the DC power source comprises one or more batteries, such as a lithium iron phosphate battery. The DC power source may be rechargeable. In particular, the DC power source may comprise one or more rechargeable batteries. The DC power source may have a capacity that allows for the storage of enough energy for one or more user experiences. For example, the DC power source may have sufficient capacity to allow for the continuous generation of aerosol for a period of around six minutes or for a period that is a multiple of six minutes. In another example, the DC power source may have sufficient capacity to allow for a predetermined number of puffs or discrete activations of the inductive heating arrangement. The DC supply voltage of the DC power source may be in a range of about 2.5 Volts to about 4.5 Volts and the DC supply current may be in a range of about 2.5 Amperes to about 5 Amperes (corresponding to a DC supply power in the range of about 6.25 Watts and about 22.5 Watts)

The DC power source may include a DC feed choke. As used herein, the term "DC feed choke" refers to an inductor used to block higher-frequency while passing direct current (DC) and lower-frequencies of alternating current (AC) in an electrical circuit.

In general, the output power of the inductive heating arrangement device is a function of both, the DC supply current as well as the DC supply voltage drawn from the DC power source. Assuming that the DC supply voltage remains substantially constant over a certain time, the DC supply current drawn from the DC power source during operation of the heating arrangement is substantially proportional to and thus indicative of the output power of the heating arrangement. Accordingly, for determining a signal indicative of the output power of the heating arrangement, the inductive heating arrangement may comprise a current sensor for determining the DC supply current drawn from the DC power source during operation of the heating arrangement. Preferably, the current sensor comprises a sensing resistor and a current shunt amplifier. The current sensor, in particular the current shunt amplifier may be configured to output a current signal indicative of the DC supply current drawn from the DC power source during operation of the heating arrangement.

In order to also take into account a possible decrease of the DC supply voltage over time, the inductive heating arrangement may further comprise a voltage sensor for determining the DC supply voltage drawn from the DC power source. For this, the voltage sensor may comprise a voltage divider. In particular, the voltage sensor may be configured to output a voltage signal indicative of the DC supply voltage drawn from the DC power source during operation of the heating arrangement. Thus, the output power of the inductive heating arrangement device may be determined as a function of both, the DC supply current as well as the DC supply voltage drawn from the DC power source.

Alternatively, as will be described in more detail further below, the current sensor and the optional voltage sensor, or at least parts thereof, such as the current shunt amplifier, the sensing resistor or the voltage divider, may be part of a calibration apparatus for tuning the output power of the heating arrangement to (micro-electro-mechanical system) tunable oscillator, a voltage-controlled oscillator (VCO) or a Colpitts oscillator(micro-electro-mechanical system) tunable oscillator, a voltage-controlled oscillator (VCO) or a Colpitts oscillator working point.

Irrespective of whether the current sensor and the optional voltage sensor are part of the heating arrangement or part of a calibration apparatus, the setup described above allows for tuning the output power of the heating arrangement to a desired working point by measuring at least the DC supply current drawn from the DC power source, and possibly in addition the DC supply voltage, while tuning the switching frequency of the switching signal provided by the tunable oscillator to the transistor switch until the measured DC supply current is within a predetermined reference range. The predetermined reference range of the measured DC supply current or of the current signal indicative thereof may be determined in advance (for example, by calibration) such as to be indicative of a desired heating performance of the heating arrangement, in particular of a desired output power of the heating arrangement.

In order to tune the output power of the heating arrangement like this, the inductive heating arrangement may comprise a controller operatively coupled to at least the current sensor and the transistor switch driver circuit. In particular, the inductive heating arrangement may comprise a controller operatively coupled to at least the current sensor and the transistor switch driver circuit in a feedback-loop configuration.

The controller may be configured to receive a current signal from the current sensor indicative of the DC supply current and to tune the switching frequency of the switching signal in response to, in particular based on, the received current signal in order to tune the DC supply current drawn from the DC power source to be in a predetermined reference range. As used herein, the term "tune the switching frequency of the switching signal in response to the received current signal" can mean that the controller is configured to set up the tunable oscillator to output a switching signal having an operating switching frequency determined in response to, in particular based on, the received current signal, for which (that is, for which operating switching frequency) the current signal received from the current sensor is in a predetermined reference range of the current signal. In other words, the controller may be configured to set the switching frequency of the switching signal to correspond to an operating switching frequency determined in response to, in particular based on, the received current signal, for which (that is, for which operating switching frequency) the current signal received from the current sensor is in a predetermined reference range of the current signal.

That is, the present invention may relate to an inductive heating arrangement for heating of an aerosol-forming substrate, wherein the heating arrangement comprises a DC power source and a power supply electronics comprising a DC/AC inverter connected to the DC power source, wherein the DC/AC inverter comprises a resonant switching power amplifier with at least one transistor switch, at least one transistor switch driver circuit associated with the transistor switch and an LC load network comprising at least a capacitor and at least an inductor, wherein the inductor is configured to generate an alternating magnetic field during operation of the heating arrangement for inductively heating the aerosol-forming substrate, wherein the transistor switch driver circuit comprises a tunable oscillator configured to output a switching signal to the transistor switch having a tunable switching frequency, wherein the heating arrangement further comprises a current sensor for determining the DC supply current drawn from the DC power source during operation of the heating arrangement, and a controller operatively coupled to the current sensor and the transistor switch driver circuit, wherein the controller is configured to receive a current signal from the current sensor indicative of the DC supply current and to set up the tunable oscillator to output a switching signal having an operating switching frequency determined in response to, in particular based on, the received current signal, for which (that is, for which operating switching frequency) the current signal received from the current sensor is in a predetermined reference range of the current signal.

In particular, the controller may be configured to compare the current signal received from the current sensor with a predetermined reference range of the current signal.

The operating switching frequency of the switching signal for which the DC supply current drawn from the DC power source during operation is in the predetermined reference range, in particular for which the current signal received from the current sensor is in the predetermined reference range of the current signal, may be determined by the controller of the heating arrangement or by a calibration apparatus for tuning the output power of the heating arrangement, which is not part of the heating arrangement. For example, such a calibration apparatus may be used for tuning the output power of the heating arrangement during the manufacture of the heating arrangement.

In the latter case, the controller of the heating arrangement may be operatively couplable to a calibration apparatus. The calibration apparatus may be configured to determine in response to, in particular based on, the current signal an operating switching frequency of the switching signal for which in operation the DC supply current drawn from the DC power source is in the predetermined range. For this, the calibration apparatus may comprise a calibration controller. The controller of the heating arrangement may be configured to communicate the current signal to the calibration apparatus, in particular to the calibration controller of the calibration apparatus, and to receive a signal communicated from the calibration apparatus, in particular from the calibration controller of the calibration apparatus, which is indicative of the determined operating switching frequency. The controller of the heating arrangement may use this signal - which is determined in response to, in particular based on, the current signal, to tune the switching frequency of the switching signal to the determined operating switching frequency in order to tune the DC supply current drawn from the DC power source to be in a predetermined reference range. Though in this configuration the operating switching frequency of the switching signal for which in operation the DC supply current drawn from the DC power source is in the predetermined range is determined by the calibration apparatus, this configuration stills falls within the scope of wording "the controller is configured to receive a current signal from the current sensor indicative of the DC supply current and to tune the switching frequency of the switching signal in response to, in particular based on, the received current signal in order to tune the DC supply current drawn from the DC power source to be in a predetermined reference range. More details of the calibration apparatus will be described further below.

Furthermore, the controller of the heating arrangement may be configured (itself) to determine (in response to, in particular based on, the current signal) an operating switching frequency of the switching signal for which the DC supply current drawn from the DC power source during operation is in the predetermined reference range, in particular for which the current signal received from the current sensor is in the predetermined reference range of the current signal.

The controller may comprise a microprocessor, for example a programmable microprocessor, a microcontroller, or an application specific integrated chip (ASIC) or other electronic circuitry capable of providing control.

Preferably, the tuning of the output power of the heating arrangement is performed during the manufacture of the heating arrangement, that is, as kind of calibration process. Preferably, this is done by using a reference susceptor arrangement, in particular in cases where the heating arrangement arranged does not comprise a susceptor arrangement itself, but where the susceptor arrangement is part of an aerosol-generating article.

Once the operating switching frequency is determined in such a calibration process, the determined operating switching frequency may be written into the tunable oscillator such that the oscillator outputs a fixed switching signal having the determined operating switching frequency. That is, once having been calibrated, the operating switching frequency of the tunable oscillator will not change anymore during the lifetime in the heating arrangement. Setting up the tunable oscillator may be accomplished by the controller, as mentioned above. That is, the controller may be configured to set up the tunable oscillator to output a switching signal having the determined operating switching frequency. That is, the controller may be configured to set the switching frequency of the switching signal to correspond to the determined operating switching frequency for which the DC supply current drawn from the DC power source is in the predetermined reference range.

The inductor of heating arrangement used for generating the alternating magnetic field may comprise at least one induction coil, that is, a single induction coil or a plurality of induction coils. The number of induction coils may depend on the number of elements, the size and the shape of the susceptor arrangement. The induction coil or coils may have a shape to conform to a shape of a housing of an aerosol-generating device the heating arrangement may be part of.

For example, the at least one induction coil may be a helical coil or flat planar coil, in particular a pancake coil or a curved planar coil. Use of a flat spiral coil allows for compact design that is robust and inexpensive to manufacture. Use of a helical induction coil advantageously allows for generating a homogeneous alternating magnetic field. As used herein a "flat spiral coil" means a coil that is generally planar coil, wherein the axis of winding of the coil is normal to the surface in which the coil lies. The flat spiral induction can have any desired shape within the plane of the coil. For example, the flat spiral coil may have a circular shape or may have a generally oblong or rectangular shape. However, the term "flat spiral coil" as used herein covers both, coils that are planar as well as flat spiral coils that are shaped to conform to a curved surface. For example, the induction coil may be a "curved" planar coil arranged at the circumference of a preferably cylindrical coil support, for example, a ferrite core. Furthermore, the flat spiral coil may comprise, for example, two layers of a four-turn flat spiral coil or a single layer of four-turn flat spiral coil. The one or more induction coils can be held within one of a housing of the heating arrangement, or a main body or a housing of an aerosol-generating device which comprises the heating arrangement. The one or more induction coils may be wound around a preferably cylindrical coil support, for example, a ferrite core.

As described above, the susceptor arrangement to be exposed to the alternating magnetic field generated by the inductor of the heating arrangement may be part of an aerosol-generating device, the heating arrangement is also part of. Alternatively, the susceptor may be part of an aerosol-generating article to be used with device which comprises the aerosol-forming substrate to be heated. It is also possible that one portion of the susceptor arrangement is part of an aerosol-generating article, whereas another portion of the susceptor arrangement is part of an aerosol-generating device. In particular in the first case, the heating arrangement according to the present invention may comprise a susceptor arrangement. As part of the heating arrangement, the susceptor arrangement may be arranged within the alternating magnetic field generated by the inductor during operation of the heating arrangement.

As used herein, the term "susceptor arrangement" refers to a component comprising at least one susceptor material that is capable to convert electromagnetic energy into heat when subjected to an alternating magnetic field. This may be the result of at least one of hysteresis losses or eddy currents induced in the susceptor material, depending on the electrical and magnetic properties of the susceptor material. Hysteresis losses occur in ferromagnetic or ferrimagnetic susceptor materials due to magnetic domains within the material being switched under the influence of the alternating magnetic field. Eddy currents are induced in electrically conductive susceptor materials. In case of an electrically conductive ferromagnetic or ferrimagnetic susceptor material, heat is generated due to both, eddy currents and hysteresis losses.

In general, the susceptor arrangement may comprise or may be formed from any material that can be inductively heated to a temperature sufficient to generate an aerosol from an aerosol-forming substrate. The susceptor arrangement may comprise a metal or carbon. The susceptor arrangement may comprise a ferromagnetic material, for example ferritic iron, or a ferromagnetic steel or stainless steel. A preferred susceptor may be formed from 400 series stainless steels, for example grade 410, or grade 420, or grade 430 stainless steel. Another suitable susceptor may comprise aluminum.

The susceptor arrangement may comprise a variety of geometrical configurations. The at least one susceptor may comprise or may be one of a susceptor pin, a susceptor rod, a susceptor blade, a susceptor strip and a susceptor plate. Where the susceptor arrangement is part of the aerosol-generating device, the susceptor pin, susceptor pin, the susceptor rod, the susceptor blade, the susceptor strip or the susceptor plate may be project into a receiving cavity of the device, preferably towards an insertion opening of the cavity for inserting an aerosol-generating article into the cavity.

The susceptor arrangement may comprise or may be a filament susceptor, a mesh susceptor, a wick susceptor. Likewise, the susceptor arrangement may comprise or may be a susceptor sleeve, a susceptor cup, a cylindrical susceptor or a tubular susceptor. Preferably, the inner void of the susceptor sleeve, the susceptor cup, the cylindrical susceptor or the tubular susceptor is configured to removably receive at least a portion of the aerosol-forming substrate to be heated. The aforementioned susceptor arrangement may have any cross-sectional shape, for example, circular, oval, square, rectangular, triangular or any other suitable shape.

The susceptor arrangement may comprise a single susceptor material. Alternatively, the susceptor arrangement may comprise at least a first susceptor material and a second susceptor material. While the first susceptor material may be optimized with regard to heat loss and thus heating efficiency, the second susceptor material may be used as temperature marker. For this, the second susceptor material preferably comprises one of a ferrimagnetic material or a ferromagnetic material. In particular, the second susceptor material may be chosen such as to have a Curie temperature corresponding to a predefined heating temperature. At its Curie temperature, the magnetic properties of the second susceptor material change from ferromagnetic or ferrimagnetic to paramagnetic, which is accompanied by a temporary change of its electrical resistance. Thus, by monitoring a corresponding change of the electrical current drawn from the DC power source it can be detected when the second susceptor material has reached its Curie temperature and, thus, when the predefined heating temperature has been reached.

The present invention further relates to an aerosol-generating device used for generating an aerosol by inductively heating an aerosol-forming substrate. The aerosol-generating device comprises an inductive heating arrangement according to present invention and as described herein.

As used herein, the term "aerosol-generating device" refers an electrically operated device that is capable of interacting with at least one aerosol-forming substrate, in particular with an aerosol-forming substrate provided within an aerosol-generating article, such as to generate an aerosol by heating the substrate by means of induction heating. Preferably, the aerosol-generating device is a puffing device for generating an aerosol that is directly inhalable by a user thorough the user's mouth. In particular, the aerosol-generating device is a hand-held aerosol-generating device.

As used herein, the term "aerosol-forming substrate" relates to a substrate capable of releasing volatile compounds that can form an aerosol upon heating the aerosol-forming substrate. Preferably, the aerosol-forming substrate is intended to be heated rather than combusted in order to release volatile compounds that can form an aerosol. The aerosol-forming substrate may be part of the aerosol-generating article. The aerosol-forming substrate may be a solid aerosol-forming substrate, a gel-like aerosol-forming substrate, a liquid aerosol-forming substrate, or any combination thereof. The aerosol-forming substrate may comprise at least one of solid and liquid components. The aerosol-forming substrate may comprise a tobacco-containing material containing volatile tobacco flavor compounds, which are released from the substrate upon heating. In particular, the aerosol-forming substrate may be tobacco-containing aerosol-forming substrate. Alternatively or additionally, the aerosol-forming substrate may comprise a non-tobacco material. The aerosol-forming substrate may further comprise an aerosol former. Examples of suitable aerosol formers are glycerin and propylene glycol. The aerosol-forming substrate may also comprise other additives and ingredients, such as nicotine or flavourants. The aerosol-forming substrate may also be a paste-like material, a sachet of porous material comprising aerosol-forming substrate, or, for example, loose tobacco mixed with a gelling agent or sticky agent, which could include a common aerosol former such as glycerin, and which is compressed or molded into a plug.

The aerosol-generating device may comprise a receiving cavity for removably receiving the aerosol-forming substrate to be heated, in particular for removably receiving at least a portion of an aerosol-generating article comprising the aerosol-forming substrate to be heated. The receiving cavity may be embedded in a housing of the aerosol-generating device.

The aerosol-generating device may comprise an overall controller for controlling operation of the device. The overall controller may comprise or may be the controller of the heating arrangement mentioned further above. The controller may comprise a microprocessor, for example a programmable microprocessor, a microcontroller, or an application specific integrated chip (ASIC) or other electronic circuitry capable of providing control.

The aerosol-generating device may also comprise a power source, in particular a DC power source, such as a battery. In particular, the aerosol-generating device may comprise a (single) overall power source. Preferably, the DC power source of the device may comprise or may be the DC power source of the heating arrangement mentioned further above.

The aerosol-generating device may comprise a main body which preferably includes the DC power source and at least parts the power supply electronics of the heating arrangement, in particular the at least one transistor switch, the at least one transistor switch driver circuit and the capacitor of the LC load network, and if present, the shunt capacitor and the DC feed choke. The inductor of the LC load network may also be part of the main body.

In addition to the main body, the aerosol-generating device may further comprise a mouthpiece, in particular in case the aerosol-generating article to be used with the device does not comprise a mouthpiece. The mouthpiece may be mounted to the main body of the device. The mouthpiece may be configured to close the receiving cavity upon mounting the mouthpiece to the main body. For attaching the mouthpiece to the main body, a proximal end portion of the main body may comprise a magnetic or mechanical mount, for example, a bayonet mount or a snap-fit mount, which engages with a corresponding counterpart at a distal end portion of the mouthpiece. In case the device does not comprise a mouthpiece, an aerosol-generating article to be used with the aerosol-generating device may comprise a mouthpiece, for example a filter plug.

The aerosol-generating device may comprise at least one air inlet, in particular an air inlet allowing air to enter the receiving cavity. For example, the air inlet may be formed by an insertion opening of the receiving cavity used for inserting the aerosol-forming substrate or the aerosol-generating article into the cavity. The aerosol-generating device may also comprise at least one air outlet, for example, an air outlet in the mouthpiece (if present). Preferably, the aerosol-generating device comprises an air path extending from the at least one air inlet through the receiving cavity, and possibly further to an air outlet in the mouthpiece, if present. Preferably, the aerosol-generating device comprises at least one air inlet in fluid communication with the receiving cavity. For example, the aerosol-generating system may comprise an air path extending from an inserting opening of the receiving cavity along an inner surface of the receiving cavity and possibly further through the aerosol-forming substrate within the article and a mouthpiece into a user's mouth.

As described above, the aerosol-generating device may further comprise a susceptor arrangement to be exposed to the alternating magnetic field generated by the inductor of the heating arrangement. As such, the susceptor arrangement may be in particular part of the heating arrangement. Details of the susceptor have been described above.

Further features and advantages of the aerosol-generating device according to the present invention have been described above with regard to the heating arrangement according to the present invention and thus equally apply.

According to the invention, there is also provided an aerosol-generating system. The system comprises an aerosol-generating device according to the present invention and as described herein as well as an aerosol-generating article for use with the device.

As used herein, the term "aerosol-generating article" refers to an article comprising at least one aerosol-forming substrate capable of releasing volatile compounds upon heating that can form an aerosol. That is, the article comprises at least one aerosol-forming substrate to be heated by the device. Preferably, the aerosol-generating article comprises at least one aerosol-forming substrate that is intended to be heated rather than combusted in order to release volatile compounds that can form an aerosol. The aerosol-generating article may be a consumable, in particular a consumable to be discarded after a single use. The aerosol-generating article may be a tobacco article. For example, the article may be a cartridge including a liquid or solid aerosol-forming substrate to be heated. Alternatively, the article may be a rod-shaped article, in particular a tobacco article, resembling conventional cigarettes and including a solid aerosol-forming substrate. Preferably, the aerosol-generating article has a circular or an elliptical or an oval or a square or a rectangular or a triangular or a polygonal cross-section.

As described above, the susceptor arrangement to be exposed to the alternating magnetic field generated by the inductor of the heating arrangement may be either part of the aerosol-generating device, or part of the aerosol-generating article aerosol-generating article. Accordingly, it is possible that the article of the aerosol-generating system comprises a susceptor arrangement in thermal contact or thermal proximity to the aerosol-forming substrate, wherein the susceptor arrangement is arranged within the alternating magnetic field generated by the inductor during operation of the heating arrangement, when the article is received in the receiving cavity of the device.

The article may comprise one or more of the following elements: a first support element, a substrate element, a second support element, a cooling element, and a mouthpiece element. Preferably, the aerosol-generating article comprises at least a first support element, a second support element and a substrate element located between the first support element and the second support element. All of the aforementioned elements may be sequentially arranged along a length axis of the article in the above described order, wherein the first support element preferably is arranged at a distal end of the article and the filter element preferably is arranged at a proximal end of the article. Each of the aforementioned elements may be substantially cylindrical. In particular, all elements may have the same outer cross-sectional shape. In addition, the elements may be circumscribed by an outer wrapper such as to keep the elements together and to maintain the desired cross-sectional shape of the rod-shaped article. Preferably, the wrapper is made of paper.

The substrate element may comprise the at least one aerosol-forming substrate and, if present, the susceptor arrangement. Preferably, the susceptor arrangement is in thermal contact with or thermal proximity to the aerosol-forming substrate.

As used herein, the term "mouthpiece element" refers to a portion of the article through which the aerosol exits the aerosol-generating article. In particular, the mouthpiece element may be placed into a user's mouth in order to directly inhale an aerosol from the article. Preferably, the mouthpiece element comprises a filter.

At least one of the first support element and the second support element may comprise a central air passage. Preferably, at least one of the first support element and the second support element may comprise a hollow cellulose acetate tube. Alternatively, the first support element may be used to cover and protect the distal front end of the substrate element.

The aerosol-cooling element is an element having a large surface area and a low resistance to draw, for example 15 mmWG to 20 mmWG. In use, an aerosol formed by volatile compounds released from the substrate element is drawn through the aerosol-cooling element before being transported to the proximal end of the aerosol-generating article.

Further features and advantages of the aerosol-generating system according to the present invention have been described with regard to the aerosol-generating device and the heating arrangement according to the present invention and thus equally apply.

The present invention further relates to a method of calibrating an inductive heating arrangement according to the present invention and as described herein. The method comprises:
operatively coupling the heating arrangement to a reference susceptor arrangement;
- operating the heating arrangement to heat the reference susceptor arrangement;
- determining the actual DC supply current drawn from the DC power source during operation of the heating arrangement;
- determining an operating switching frequency of the switching signal for which in operation the actual DC supply current drawn from the DC power source is in the predetermined range;
- setting up the tunable oscillator to output a switching signal having the determined operating switching frequency.

In particular, the present invention further may relate to a method of calibrating an inductive heating arrangement according to the present invention and as described herein, wherein the method comprises:
- operatively coupling the heating arrangement to a reference susceptor arrangement;
- operating the heating arrangement to heat the reference susceptor arrangement;
- determining the actual DC supply current drawn from the DC power source during operation of the heating arrangement;
- tuning the switching frequency of the switching signal while determining the actual DC supply current drawn from the DC power source until the actual DC supply current is in a predetermined range;
- determining an operating switching frequency of the switching signal for which in operation the actual DC supply current drawn from the DC power source is in the predetermined range;
- setting up the tunable oscillator to output a switching signal having the determined operating switching frequency.

As described further above with regard to the heating arrangement according to the present invention, it has be found that the output power of the heating arrangement may be calibrated to a desired working point by measuring at least the DC supply current drawn from the DC power source, by determining in response to, in particular based on the DC supply current or a signal indicative thereof, an operating switching frequency of the switching signal for which the DC supply current drawn from the DC power source during operation is in a predetermined reference range, in particular for which a current signal received from the current sensor is in a predetermined reference range of the current signal, and subsequently by setting up the tunable oscillator to output a switching signal having a switching frequency for which the actual DC supply current drawn from the DC power source is in a predetermined range. In particular, the operating switching frequency of the switching signal may be determined by calculating a frequency shift using a pre-known function between the DC current and the switching frequency (current change as function of frequency change) to be applied to the switching frequency at which the DC supply current associated to the received current signal was measured. This can be realized either by the controller of the heating arrangement or a calibration apparatus operatively couplable/coupled to the controller of the heating arrangement. Afterwards, the DC current may be measured again at the shifted switching frequency to verify whether in operation the DC supply current drawn from the DC power source is in the predetermined range for the shifted switching frequency.

Likewise, the output power of the heating arrangement may be calibrated to a desired working point by measuring at least the DC supply current drawn from the DC power source, while tuning the switching frequency of the switching signal until the measured DC supply current is within a predetermined reference range, and subsequently by setting up the tunable oscillator to output a switching signal having a switching frequency for which the actual DC supply current drawn from the DC power source is in a predetermined range.

Advantageously, this calibration allows less strict requirements to be placed on the component tolerances, while still keeping performance variations of the output power within acceptable limits.

The actual DC supply current may be determined continuously while tuning the switching frequency. It is also possible that the switching frequency is tuned step-wise, in particular through a plurality of frequency values, wherein for each tuning step, in particular for each frequency value the respective actual DC supply current is determined. In particular, the step of tuning the switching frequency to a new frequency value and the step of determining the respective actual DC supply current may alternate.

Likewise, the actual DC supply current may be measured at a singular pre-specified (fixed) switching frequency, for example, at a preset switching frequency of as specified by the supplier of the tunable oscillator. This measured may be repeated for verification or determination of a mean value. The "new" switching frequency for which the outpower is in the desired range may then be determined by calculating a frequency shift using a pre-known function between the DC current and the switching frequency (current change as function of frequency change) which subsequently may be applied to the pre-specified switching frequency at which the (singular) DC supply current associated to the received current signal was measured. This process does not involve a feedback loop or a comparison of the DC current signal received from the current sensor with a predetermined reference range of the current signal. Preferably, this kind of calibration is performed during the manufacture of the heating arrangement.

Further features and advantages of the calibration method according to the present invention have been described with regard to the heating arrangement according to the present invention and thus equally apply.

The present invention further relates to a calibration apparatus for calibrating the output power of an inductive heating arrangement according to the present invention and as described herein, in particular for usage in a method for calibrating an inductive heating arrangement according to the present invention and as described herein. The calibration apparatus may comprise a reference susceptor arrangement and a current sensor for determining the DC supply current drawn from the DC power source during operation of the heating arrangement.

The reference susceptor arrangement preferably is of the same type as the susceptor arrangement to be used later in operation of the heating arrangement for heating the aerosol-forming substrate. Also, the reference susceptor arrangement may be placed at the same place position with respect to the inductor of the heating arrangement as the actual susceptor arrangement to be used later on for heating the aerosol-forming substrate.

Preferably, the current sensor comprises a sensing resistor and a current shunt amplifier. The current sensor, in particular the current shunt amplifier may be configured to output a current signal indicative of the DC supply current drawn from the DC power source during operation of the heating arrangement.

In order to take into account a possible decrease of the DC supply voltage over time, the calibration apparatus may further comprise a voltage sensor for determining the DC supply voltage drawn from the DC power source. For this, the voltage sensor may comprise a voltage divider. The voltage sensor preferably is configured to output a voltage signal indicative of the DC supply voltage drawn from the DC power source during operation of the heating arrangement. Thus, the output power of the inductive heating arrangement device may be determined as a function of both, the DC supply current as well as the DC supply voltage drawn from the DC power source.

The current sensor and - if present - the voltage sensor may be operatively couplable to the controller of the heating arrangement in order to provide the controller of the heating arrangement with a respective signal indicative of the DC supply current and the DC supply voltage, respectively. This in turn enables the controller of the heating arrangement to determine whether the measured DC supply current is within a predetermined reference range while tuning the switching frequency of the switching signal.

Alternatively, the calibration apparatus may comprise a calibration controller itself which is operatively coupled to the current sensor of the calibration apparatus and operatively couplable to the transistor switch driver circuit of the heating arrangement in a feedback-loop configuration. Like the controller of the heating arrangement, the calibration controller may be configured to receive a current signal from the current sensor indicative of the DC supply current and to tune the switching frequency of the switching signal in response to the received current signal in order to tune the DC supply current drawn from the DC power source to be in a predetermined range.

Furthermore, the calibration controller may be configured to determine an operating switching frequency of the switching signal for which in operation the DC supply current drawn from the DC power source is in the predetermined range. The calibration controller may also be configured to set up the tunable oscillator to output a switching signal having the determined operating switching frequency.

The present invention further relates to a calibration apparatus for calibrating the output power of an inductive heating arrangement according to the present invention and as described herein, in particular for usage in a method for calibrating an inductive heating arrangement according to the present invention and as described herein, wherein the calibration apparatus comprises a reference susceptor arrangement inductively couplable to the inductor of the heating arrangement and a calibration controller operatively couplable to the controller of the heating arrangement. The calibration controller may be configured to receive the current signal communicated from the controller of the heating arrangement, to determine in response to, in particular based on, the current signal the operating switching frequency of the switching signal for which in operation the DC supply current drawn from the DC power source is in the predetermined range, and to communicate a signal indicative of the determined operating switching frequency to the controller of the heating arrangement.

As mentioned above with respect to the calibration method, the actual DC supply current communicated to the calibration controller may a single (mean) value measured at a singular pre-specified (fixed) switching frequency, for example, at a preset switching frequency of as specified by the supplier of the tunable oscillator which then is used to calculate a frequency shift that is applied to the pre-specified switching frequency at which the (singular) DC supply current associated to the received current signal was measured in order to determine the "new" switching frequency for which the outpower is in the desired range. Accordingly, the calibration controller may be configured to determine the operating switching frequency of the switching signal by calculating a frequency shift using a pre-known function between the DC current and the switching frequency (current change as function of frequency change) to be applied to the switching frequency at which the DC supply current associated to the received current signal was measured. Afterwards, the DC current may be measured again at the shifted switching frequency to verify whether in operation the DC supply current drawn from the DC power source is in the predetermined range for the shifted switching frequency.

Further features and advantages of the calibration apparatus according to the present invention have been described with regard to the heating arrangement and the calibration method according to the present invention and thus equally apply.

The invention is defined in the claims.

The present disclosure will now be further described with reference to the figures in which:
- Fig. 1: schematically illustrates an exemplary embodiment of an aerosol-generating system 1 according to the present invention;
- Fig. 2: shows a first exemplary embodiment of an inductive heating arrangement according to the present invention, which may be used in the aerosol-generating device according to Fig. 1;
- Fig. 3: schematically illustrates the nominal resonance curve and the actual resonance curve of the inductive heating arrangement according to Fig. 2;
- Fig. 4: exemplarily illustrates an embodiment of a method for calibrating the output power of the heating arrangement according to Fig. 2;
- Fig. 5: shows an example of the current sensor 40 used in the heating arrangement according; and
- Fig. 6: shows a second exemplary embodiment of an inductive heating arrangement according to the present invention, which may be alternatively used in the aerosol-generating device according to Fig. 1.

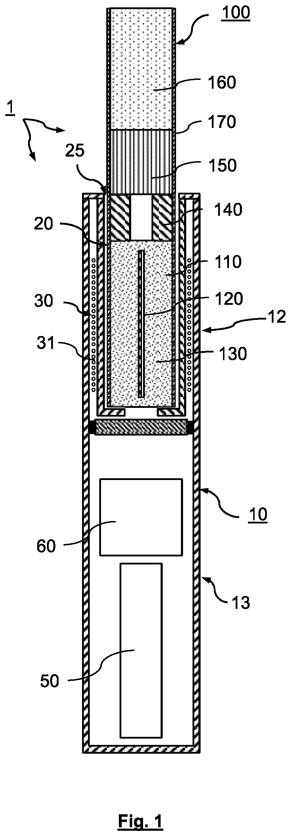

**Fig. 1** schematically illustrates an exemplary embodiment of an aerosol-generating system 1 according to the present invention. The system 1 comprises an aerosol-generating device 10 as well as an aerosol-generating article 100 for use with the device which comprises an aerosol-forming substrate to be heated to form an inhalable aerosol.

The aerosol-generating article 100 is a rod-shaped consumable comprising four elements sequentially arranged in coaxial alignment: an aerosol-forming rod segment 110, a support element 140 having a central air passage, an aerosol-cooling element 150 and a mouthpiece element 160 comprising a filter. The aerosol-forming rod segment 110 is arranged at a distal end of the article 100 and comprises a strip-shaped susceptor arrangement 120 and the aerosol-forming substrate 130 to be heated. In contrast, the mouthpiece element 160 is arranged at a proximal end of the article 100 allowing a user to puff thereon. The support element 140 and the aerosol-cooling element 150 are arranged in between. Each of the four elements is a substantially cylindrical element, all of them having substantially the same diameter. The four elements are circumscribed by an outer wrapper 170 such as to keep the four elements together and to maintain the desired circular cross-sectional shape of the rod-like article 100. The wrapper 170 preferably is made of paper. Further details of the article, in particular of the four elements, are described in WO 2015/176898 A1.

The aerosol-generating device 10 comprises a cylindrical receiving cavity 20 defined within a proximal portion 12 of the device 10 for receiving a least a distal portion of the article 100 therein. The device 10 further comprises an inductive heating arrangement 30 including an inductor 31 for generating an alternating high-frequency magnetic field. In the present embodiment, the inductor 31 is a helical coil circumferentially surrounding the cylindrical receiving cavity 20. The coil 31 is arranged such that the susceptor arrangement 120 of the aerosol-generating article 100 is exposed to the alternating magnetic field upon engaging the article 100 with the device 10. Thus, when activating the inductive heating arrangement 30, the susceptor arrangement 120 heats up due to eddy currents and/or hysteresis losses that are induced by the alternating magnetic field within the susceptor arrangement 120, depending on its magnetic and electric material properties. The susceptor arrangement 120 is heated until reaching an operating temperature sufficient to vaporize the aerosol-forming substrate 130 surrounding the susceptor arrangement 120 within the article 100. Within a distal portion 13, the aerosol-generating device 10 further comprises a DC power source 50 and a controller 60 (illustrated in Fig. 1 schematically only) for powering and controlling the heating process.

Even though being part of the aerosol-generating article 100, the susceptor arrangement 120 may be considered as part of the inductive heating arrangement 30. The same holds for the DC power source 50 and the controller 60.

In use of the system 1, when a user takes a puff at the mouthpiece element 160 of the article 100, air is drawn into the cavity 20 at the rim of an article insertion opening 25 of the cavity 20. The air flow further extends towards the distal end of the cavity 20 through a passage which is formed between the inner surface of the cylindrical cavity 20 and the outer surface of the article 100. At the distal end of the cavity 20, the air flow enters the aerosol-generating article 100 through the substrate element 110 and further passes through the support element 140, the aerosol cooling element 150 and the mouthpiece element 160, where it finally exits the article 100. In the substrate element 110, vaporized material from the aerosol-forming substrate 130 is entrained into the air flow. Subsequently, when passing through the support element 140, the cooling element 150 and the mouthpiece element 160, the air flow including the vaporized material cools down such as to form an inhalable aerosol escaping the article 10 through the mouthpiece element 160.

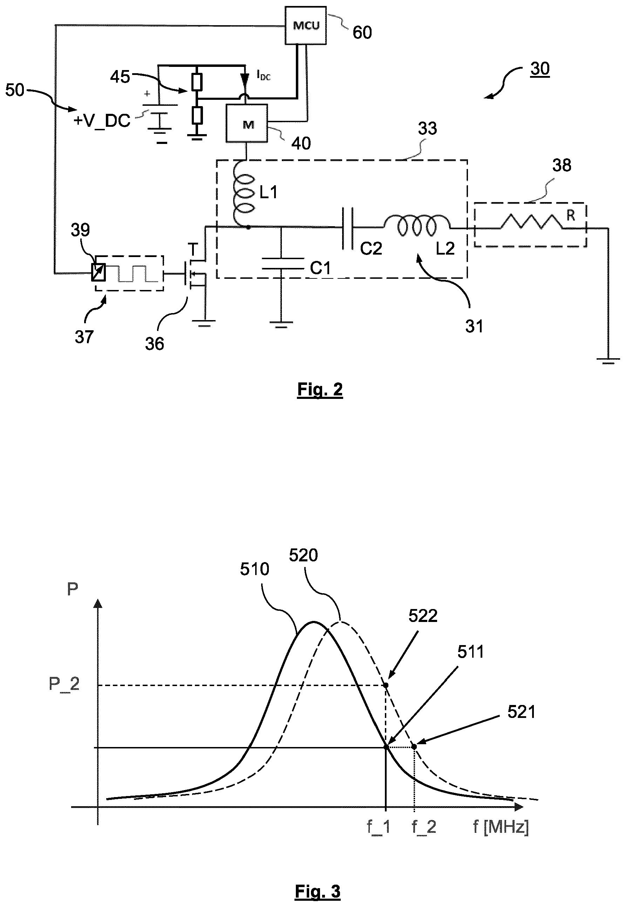

**Fig. 2** shows an exemplary embodiment of the inductive heating arrangement 30 according to the present invention, which may be implemented in the aerosol-generating device 10 according to Fig. 1. According to the invention, the inductive heating arrangement 30 comprises a DC/AC inverter which is connected to the DC power source 50. In the present embodiment, the DC/AC inverter includes a class-E power amplifier, that is, a resonant switching power amplifier, which comprises the following components: a transistor switch 36 comprising a Field Effect Transistor T (FET), for example a Metal-Oxide-Semiconductor Field Effect Transistor (MOSFET), a transistor switch supply circuit 37 including an oscillator for supplying a switching signal (gate-source voltage) to the transistor switch 36, and an LC load network 33 comprising a shunt capacitor C1 and a series connection of a capacitor C2 and inductor L2. The inductor L2 corresponds to the inductor 31 shown in Fig. 1 which is configured to generate an alternating magnetic field within the cavity 20 during operation of the system 1. In addition, there is provided a DC feed choke L1 for supplying the DC supply voltage +V_DC from to the DC power source 50. Also shown in Fig. 2 is the ohmic resistance R representing the total equivalent resistance or total resistive load 38, which in operation corresponds to the sum of the ohmic resistance of the inductor 31, marked as L2, and the ohmic resistance of the susceptor arrangement 120 shown in Fig. 1. In case no article is inserted in the cavity 20, the equivalent resistance or resistive load 38 only corresponds to the ohmic resistance of the inductor 31. Further details of the inductive heating arrangement 30 according to the present embodiment, in particular with regard to its working principle, are disclosed, for example, in WO 2015/177046 A1.

Due to manufacturing tolerances of the electronic components, in particular of the capacitor C2 and the inductor L2, the actual resonance curve of the LC load network 33 may deviate from the nominal resonance curve. This is shown in Fig. 3, where the solid curved line represents the nominal resonance curve 510 of the LC load network 33 as defined by the nominal values of the capacitor C2 and the inductor L2, and the dashed curved line represents the actual resonance curve 520 of the LC load network 33 as defined by the actual values of the capacitor C2 and the inductor L2. So far, the switching frequency f_1 of the switching signal to be provided by the transistor switch supply circuit 37 to the transistor switch 36 has been determined with respect to the nominal resonance curve 510, that is, with respect to a specific working point 511 on the nominal resonance curve 510 that is associated with a desired target output power P_1. However, as further shown in Fig. 3, the deviation from the nominal resonance curve 510 may cause the effective working point of the power amplifier for the given switching frequency f_1 to be at a point 522 on the actual resonance curve 520 that is associated with an outpower P_2 different from the desired target output P1. Hence, this deviation may result in a deviation of the output power of the heating arrangement 30 from its nominal value. For example, a tolerance of more than ±1 percent of the nominal inductance of the inductor L2 and the nominal capacitance of the capacitor C2 of the LC load network 33 may result in a variation of more than ±17 percent in the output power of the heating arrangement 30. Typically, this is not acceptable. Instead of using capacitors and inductors with tighter tolerances, the heating arrangement 30 according to the present invention involves a transistor switch driver circuit 37 comprising a tunable oscillator 39 which is configured to output a switching signal to the transistor switch 36 having a tunable switching frequency. As also shown in Fig. 3, this allows for tuning the switching frequency of the switching signal in order to shift the effective working point on the actual resonance curve of the LC load network to a point 521 or into a sufficiently small range around a point 521 that is associated with the desired target output power P_1. Thus, by tuning the switching frequency of the switching signal from value f_1 to value f_2 as shown in Fig. 3, the resonant switching power amplifier can be effectively tuned to a desired working point. As a result, the variation in the output power can be significantly limited, while at the same time the requirements for the tolerances of the capacitors and inductors can be set lower. In the present example shown in Fig. 3, the switching frequency is tuned to a desired range offset to the actual resonance frequency of the LC load network.

Tuning of the output power of the heating arrangement preferably is performed during the manufacture of the heating arrangement, that is, as kind of calibration process. This is preferably done using a reference susceptor arrangement (not shown in Fig 2), in particular in cases where the actual susceptor arrangement used for heating the aerosol-forming substrate is part of an aerosol-generating article, as shown in Fig. 1.

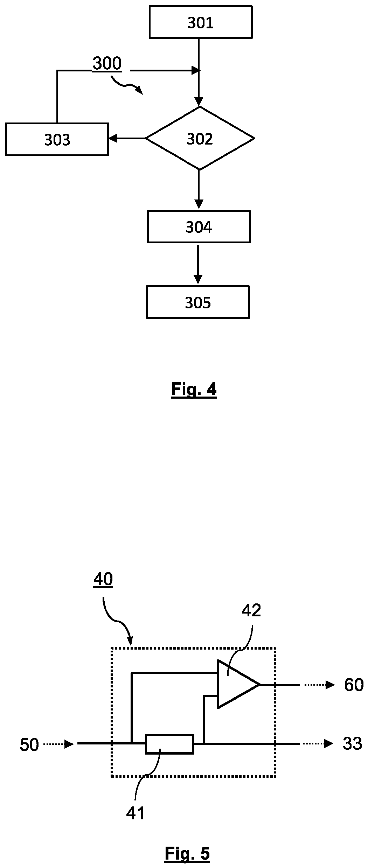

**Fig. 4** exemplarily illustrates an embodiment of a method 300 for calibrating the output power of the heating arrangement 30 according to Fig. 2. In a first step 301, a reference susceptor arrangement (not shown) is operatively coupled to the heating arrangement 30. With reference to the aerosol-generating device 10 in Fig. 1, the reference susceptor arrangement may be, for example, inserted into the receiving cavity 20 of the device 10. Preferably, the reference susceptor arrangement is of the same type and placed at the same position in the receiving cavity 20 as the susceptor arrangement 120 within the aerosol-generating article 100 that is to be used with the device later on to heat the substrate. In a next step 302, the heating arrangement 10 is operated to heat the reference susceptor arrangement. During operation of the heating arrangement, the actual DC supply current drawn from the DC power source 50 is determined. For this, the heating arrangement 30 may comprise a current sensor 40, as shown in Fig. 2. Details of the current sensor will be described further below with regard to Fig. 5. The determined actual DC supply current is compared with a predetermined range. When the determined actual DC supply current is not within a predetermined range, the switching frequency of the switching signal provided by the transistor switch supply circuit 37 to transistor switch 36 is changed in order to get the effective working point on the actual resonance curve of the LC load network to a position or into a sufficiently small range associated with a desired target output power. This is shown by step 303 in Fig. 4. The switching frequency is tuned until the determined actual DC supply current is in a predetermined range that is associated with a desired target output power (see Fig. 3). The actual DC supply current may be determined continuously while tuning the switching frequency. It is also possible that the switching frequency is tuned step-wise, in particular through a plurality of frequency values, wherein for each tuning step, in particular for each frequency value, the respective actual DC supply current is determined. The step of tuning the switching frequency to a new frequency value and the step of determining the respective actual DC supply current may alternate. In a next step 304, when the determined actual DC supply current is in a predetermined range, an operating switching frequency of the switching signal for which in operation the actual DC supply current drawn from the DC power source is in the predetermined rang is determined. Finally, in step 305, the tunable oscillator is set up to output a switching signal having the determined operating switching frequency.

For determining the DC supply current drawn from the DC power source 50 during operation of the heating arrangement, the inductive heating arrangement 30 may comprise a current sensor 40 as shown in Fig 2. The current sensor 40 is configured to output a current signal indicative of the DC supply current. As shown in **Fig. 5****,** the current sensor 40 may comprise a sensing resistor 41 and a current shunt amplifier 42. In order to account for a possible decrease of the DC supply voltage over time, the inductive heating arrangement 30 may further comprise a voltage sensor 45 for determining the DC supply voltage drawn from the DC power source 50. As shown in Fig. 2, the voltage sensor 45 may comprise a voltage divider. The voltage sensor 45 may be configured to output a voltage signal indicative of the DC supply voltage drawn from the DC power source during operation of the heating arrangement. Thus, the output power of the inductive heating arrangement device may be determined as a function of both, the DC supply current as well as the DC supply voltage drawn from the DC power source 50.

In order to tune the output power of the heating arrangement, in particular to tune the switching frequency of the tunable oscillator 39 to a desired working point on the actual resonance curve of the LC load network, for example, in a desired range around or offset to the resonance frequency of the LC load network 33, the current sensor 40, the tunable oscillator 39 and - if present - the voltage sensor 45 are operatively coupled to the controller 60 in a feedback-loop configuration, as shown in Fig. 2. The controller 60 may be the same as shown in Fig. 1 and configured to receive the current signal from the current sensor 40 indicative of the DC supply current. Furthermore, the controller 60 is configured to tune the switching frequency of the switching signal output by the tunable oscillator in response to the received current signal in order to tune the DC supply current drawn from the DC power source to be in the predetermined range as described above with respect to the calibration method shown in Fig. 4. The controller 60 may be further configured to determine an operating switching frequency of the switching signal for which in operation the DC supply current drawn from the DC power source 50 is in the predetermined range. Also, the controller 60 may be configured to set up the tunable oscillator 39 to output a switching signal having the determined operating switching frequency. That is the determined operating switching frequency may be written into the tunable oscillator 39 such that the oscillator 39 outputs a fixed switching signal having the determined operating switching frequency.

Instead of using an internal current sensor 40, the calibration method may also be performed using a separate calibration apparatus. In addition to the reference susceptor arrangement mentioned above, the calibration apparatus may comprise a current sensor for determining the DC supply current drawn from the DC power source during operation of the heating arrangement. The current sensor of the current sensor may be configured in the same way as describe above with regard to the current sensor 40 shown in Fig. 2 and Fig. 5. The calibration apparatus may also comprise a voltage sensor as described above for determining the DC supply voltage drawn from the DC power source 50 in order to take into account a possible decrease of the DC supply voltage over time.

The current sensor and - if present - the voltage sensor of the calibration apparatus may be operatively couplable to the controller 60 of the heating arrangement 30 or the aerosol-generating device, respectively. Alternatively, instead of using the internal controller 60, the calibration apparatus may comprise a calibration controller itself. The calibration controller may be operatively coupled to the current sensor of the calibration apparatus and operatively couplable to the transistor switch driver circuit of the heating arrangement in a feedback-loop configuration. The calibration controller may be configured in the same way as described above with regard to the internal controller 60 shown in Fig. 1 and Fig. 2.

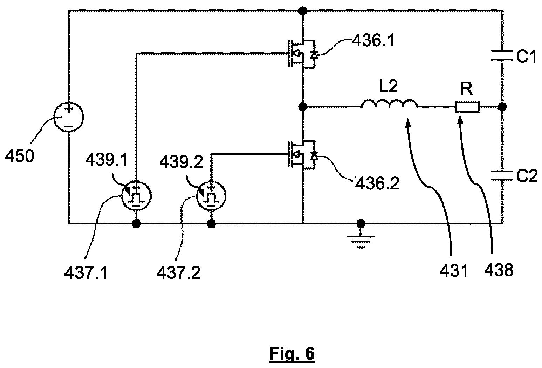

Fig. 6 shows a second exemplary embodiment of an inductive heating arrangement 430 according to the present invention, which may be alternatively used in the aerosol-generating device according to Fig. 1. As far as the inductive heating arrangement 430 comprises the same or similar features as the inductive heating arrangement 30 according to Fig. 2, the same reference signs are used in Fig 5, yet incremented by 400. Instead of a class-E amplifier, the inductive heating arrangement 430 according to Fig. 6 comprises a class-D amplifier which comprises two transistor switches 436.1 and 436.2 in order to provide a high frequency oscillating current to an inductor 431 which in turn is used to generate the alternating magnetic field for heating the susceptor arrangement. Like in Fig. 2, the inductor 431 is again indicated by L2 and the combined ohmic resistance 438 of the inductor 431 and the susceptor arrangement is indicated by R. The inductive heating arrangement 430 further comprises a DC power source 450 connected to the two transistor switches 436.1 and 436.2. Two transistor switch driver circuits 437.1 and 437.2 are provided for switching two the transistor switches 436.1 and 436.2 on and off. The switches are controlled at high frequency in a manner so as to make sure that one of the two transistor switches 436.1 and 436.2 has been switched off at the time the other of the two transistors is switched on. In order to allow for tuning the output power of the inductive heating arrangement 430, each of the two transistor switch driver circuits 437.1 and 437.2 comprises a tunable oscillator 439.1 and 439.2 configured to output a switching signal to the respective transistor switch 436.1 and 436.2 having a tunable switching frequency. By this, the heating arrangement 430 according to Fig. 6 can be calibrated in the same way as described above with respect to Fig. 4. The values of C1 and C2 can be chosen to maximize the efficient dissipation of power in the susceptor arrangement.

For the purpose of the present description and of the appended claims, except where otherwise indicated, all numbers expressing amounts, quantities, percentages, and so forth, are to be understood as being modified in all instances by the term "about". Also, all ranges include the maximum and minimum points disclosed and include any intermediate ranges therein, which may or may not be specifically enumerated herein. In this context, therefore, a number A is understood as A ± 5 percent of A. Within this context, a number A may be considered to include numerical values that are within general standard error for the measurement of the property that the number A modifies. The number A, in some instances as used in the appended claims, may deviate by the percentages enumerated above provided that the amount by which A deviates does not materially affect the basic and novel characteristic(s) of the claimed invention. Also, all ranges include the maximum and minimum points disclosed and include any intermediate ranges therein, which may or may not be specifically enumerated herein.

## Claims

1. An inductive heating arrangement for heating of an aerosol-forming substrate, wherein the heating arrangement comprises a DC power source and a power supply electronics comprising a DC/AC inverter connected to the DC power source, wherein the DC/AC inverter comprises a resonant switching power amplifier with at least one transistor switch, at least one transistor switch driver circuit associated with the transistor switch and an LC load network comprising at least a capacitor and at least an inductor, wherein the inductor is configured to generate an alternating magnetic field during operation of the heating arrangement for inductively heating the aerosol-forming substrate, wherein the transistor switch driver circuit comprises a tunable oscillator configured to output a switching signal to the transistor switch having a tunable switching frequency, wherein the heating arrangement further comprises a current sensor for determining the DC supply current drawn from the DC power source during operation of the heating arrangement, and a controller configured to receive a current signal from the current sensor indicative of the DC supply current and to tune the switching frequency of the switching signal in response to the received current signal in order to tune the DC supply current drawn from the DC power source to be in a predetermined range.

2. The inductive heating arrangement according to claim 1, wherein the switching frequency is tunable in a range of ±20 percent, in particular ±10 percent, preferably ±5 percent around a center frequency.

3. The inductive heating arrangement according to any one of the preceding claims, wherein the switching frequency is tunable in a range between 5.4 MHz and 8 MHz, in particular between 6.0 MHz and 7.5 MHz, preferably between 6.4 MHz and 7.2 MHz.

4. The inductive heating arrangement according to any one of the preceding claims, wherein a tolerance of a capacitance of the capacitor is in a range between ±2 percent and ±4 percent of a nominal capacitance value of the capacitor.

5. The inductive heating arrangement according to any one of the preceding claims, wherein a tolerance of an inductance of the inductor is in a range between ± 3 percent and ±7 percent, in particular between ± 4 percent and ±6 percent, preferably of ±5 percent a nominal inductance value of the inductor.

6. The inductive heating arrangement according to any one of the preceding claims, wherein the switching power amplifier is one of a class-C power amplifier, a class-D power amplifier and a class-E power amplifier.

7. The inductive heating arrangement according to any one of the preceding claims, wherein the controller is configured to set up the tunable oscillator to output a switching signal having an operating switching frequency determined in response to the received current signal, for which operating switching frequency the DC supply current drawn from the DC power source is in the predetermined range.

8. The inductive heating arrangement according to any one of the preceding claims, wherein the controller is operatively couplable to a calibration apparatus configured to determine in response to the current signal the operating switching frequency of the switching signal for which in operation the DC supply current drawn from the DC power source is in the predetermined range, wherein the controller is configured to communicate the current signal to the calibration apparatus and to receive a signal communicated from the calibration apparatus indicative of the determined operating switching frequency.

9. The inductive heating arrangement according to any one of claims 1 to 7, wherein the controller is operatively coupled to the current sensor and the transistor switch driver circuit in a feedback-loop configuration.

10. The inductive heating arrangement according to claim 9, wherein the controller is configured to determine, in particular in response to the current signal, the operating switching frequency of the switching signal for which in operation the DC supply current drawn from the DC power source is in the predetermined range.

11. The inductive heating arrangement according to any one of the preceding claims, further comprising a susceptor arrangement, wherein the susceptor arrangement is arranged within the alternating magnetic field generated by the inductor during operation of the heating arrangement.

12. A method of calibrating an inductive heating arrangement according to any one of claims 1 to 11, the method comprising:
- operatively coupling the heating arrangement to a reference susceptor arrangement;
- operating the heating arrangement to heat the reference susceptor arrangement;
- determining the actual DC supply current drawn from the DC power source during operation of the heating arrangement;
- determining an operating switching frequency of the switching signal for which in operation the actual DC supply current drawn from the DC power source is in the predetermined range;
- setting up the tunable oscillator to output a switching signal having the determined operating switching frequency switching frequency.

13. The method according to claim 12, wherein determining the operating switching frequency comprises tuning the switching frequency of the switching signal while determining the actual DC supply current drawn from the DC power source until the actual DC supply current is in a predetermined range.

14. A calibration apparatus for calibrating an inductive heating arrangement according to any one of claims 1 to 11, in particular for usage in a method according to claim 12, wherein the calibration apparatus comprises a reference susceptor arrangement inductively couplable to the inductor of the heating arrangement and a calibration controller operatively couplable to the controller of the heating arrangement, wherein the calibration controller is configured to receive the current signal communicated from the controller of the heating arrangement, to determine in response to the current signal the operating switching frequency of the switching signal for which in operation the DC supply current drawn from the DC power source is in the predetermined range, and to communicate a signal indicative of the determined operating switching frequency to the controller of the heating arrangement.

15. The calibration apparatus according to claim 14, wherein the calibration controller is configured to determine the operating switching frequency of the switching signal by calculating a frequency shift using a pre-known function between the DC current and the switching frequency to be applied to the switching frequency at which the DC supply current associated to the received current signal was measured.

## Patentansprüche

1. Induktive Erwärmungsanordnung zum Erwärmen eines aerosolbildenden Substrats, wobei die Erwärmungsanordnung eine Gleichstromquelle und eine Energieversorgungselektronik umfasst, die einen Gleichstrom/Wechselstrom-Wandler umfasst, der mit der Gleichstromquelle verbunden ist, wobei der Gleichstrom/Wechselstrom-Wandler einen Resonanzschaltungsleistungsverstärker mit wenigstens einem Transistorschalter, wenigstens einer dem Transistorschalter zugewiesenen Transistorschalter-Treiberschaltung und einem LC-Lastnetzwerk umfasst, das wenigstens einen Kondensator und wenigstens einen Induktor umfasst, wobei der Induktor ausgelegt ist, um ein magnetisches Wechselfeld während des Betriebs der Erwärmungsanordnung zum induktiven Erwärmen des aerosolbildenden Substrats zu erzeugen, wobei die Transistorschalter-Treiberschaltung einen abstimmbaren Oszillator umfasst, der ausgelegt ist, ein Schaltsignal an den Transistorschalter auszugeben, das eine abstimmbare Schaltfrequenz aufweist, wobei die Erwärmungsanordnung ferner einen Stromsensor zum Ermitteln des von der Gleichstromquelle während des Betriebs der Erwärmungsanordnung entnommenen Gleichstromversorgungsstrom umfasst, und eine Steuerung, die ausgelegt ist, ein den Gleichstromversorgungsstrom anzeigendes Stromsignal von dem Stromsensor zu empfangen und die Schaltfrequenz des Schaltsignals in Reaktion auf das empfangene Stromsignal abzustimmen, um den von der Gleichstromquelle entnommenen Gleichstromversorgungsstrom so abzustimmen, dass er in einem vorgegebenen Bereich liegt.

2. Induktive Erwärmungsanordnung nach Anspruch 1, wobei die Schaltfrequenz in einem Bereich von 120 Prozent, insbesondere ±10 Prozent, bevorzugt ±5 Prozent um eine Mittenfrequenz abstimmbar ist.

3. Induktive Erwärmungsanordnung nach einem beliebigen der vorhergehenden Ansprüche, wobei die Schaltfrequenz in einem Bereich zwischen 5,4 MHz und 8 MHz, insbesondere zwischen 6,0 MHz und 7,5 MHz, bevorzugt zwischen 6,4 MHz und 7,2 MHz, abstimmbar ist.

4. Induktive Erwärmungsanordnung nach einem beliebigen der vorhergehenden Ansprüche, wobei eine Toleranz einer Kapazität des Kondensators in einem Bereich zwischen ±2 Prozent und ±4 Prozent eines Nennkapazitätswertes des Kondensators liegt.

5. Induktive Erwärmungsanordnung nach einem beliebigen der vorhergehenden Ansprüche, wobei eine Toleranz einer Induktivität des Induktors in einem Bereich zwischen ±3 Prozent und ±7 Prozent, insbesondere zwischen ±4 Prozent und ±6 Prozent, bevorzugt von ±5 Prozent eines Nenninduktivitätswertes des Induktors liegt.

6. Induktive Erwärmungsanordnung nach einem beliebigen der vorhergehenden Ansprüche, wobei der Schaltleistungsverstärker ein Klasse-C-Leistungsverstärker, ein Klasse-D-Leistungsverstärker oder ein Klasse-E-Leistungsverstärker ist.

7. Induktive Erwärmungsanordnung nach einem beliebigen der vorhergehenden Ansprüche, wobei die Steuerung ausgelegt ist, den abstimmbaren Oszillator so einzustellen, dass er ein Schaltsignal mit einer in Reaktion auf das empfangene Leistungssignal bestimmten Betriebsschaltfrequenz ausgibt, für die der aus der Gleichstromquelle entnommene Gleichstromversorgungsstrom in dem vorgegebenen Bereich liegt.

8. Induktive Erwärmungsanordnung nach einem der vorhergehenden Ansprüche, wobei die Steuerung betriebsfähig mit einer Kalibrierungsvorrichtung koppelbar ist, die ausgelegt ist, um in Reaktion auf das Stromsignal die Betriebsschaltfrequenz des Schaltsignals zu bestimmen, für das im Betrieb der von der Gleichstromquelle entnommene Gleichstromversorgungsstrom in dem vorbestimmten Bereich liegt, wobei die Steuerung ausgelegt ist, um das Stromsignal an die Kalibrierungsvorrichtung zu übermitteln und ein von der Kalibrierungsvorrichtung übermitteltes Signal zu empfangen, das die bestimmte Betriebsschaltfrequenz anzeigt.

9. Induktive Erwärmungsanordnung nach einem der Ansprüche 1 bis 7, wobei die Steuerung mit dem Stromsensor und dem Transistorschalter-Treiberkreis in einer Rückkopplungsschleifenkonfiguration wirkverbunden ist.

10. Induktive Erwärmungsanordnung nach Anspruch 9, wobei der Regler ausgelegt ist, um insbesondere in Reaktion auf das Stromsignal die Betriebsschaltfrequenz des Schaltsignals zu bestimmen, für das im Betrieb der aus der Gleichstromquelle entnommene Gleichstromversorgungsstrom in dem vorgegebenen Bereich liegt.

11. Induktive Erwärmungsanordnung nach einem beliebigen der vorhergehenden Ansprüche, ferner umfassend eine Suszeptoranordnung, wobei die Suszeptoranordnung innerhalb des magnetischen Wechselfeldes angeordnet ist, das durch den Induktor während des Betriebs der Erwärmungsanordnung erzeugt wird.

12. Verfahren zum Kalibrieren einer induktiven Erwärmungsanordnung nach einem beliebigen der Ansprüche 1 bis 11, das Verfahren umfassend:
- Wirkverbinden der Erwärmungsanordnung mit einer Referenzsuszeptoranordnung;
- Betreiben der Erwärmungsanordnung, um die Referenzsuszeptoranordnung zu erwärmen;
- Bestimmen des tatsächlichen Gleichstromversorgungsstroms, der der Gleichstromquelle während des Betriebs der Erwärmungsanordnung zugeführt wird;
- Bestimmen einer Betriebsschaltfrequenz des Schaltsignals, bei der im Betrieb der tatsächliche von der Gleichstromquelle entnommene Gleichstromversorgungsstrom in dem vorgegebenen Bereich liegt;
- Einstellen des abstimmbaren Oszillators, um ein Schaltsignal auszugeben, das die bestimmte Betriebsschaltfrequenz-Schaltfrequenz aufweist.

13. Verfahren nach Anspruch 12, wobei Bestimmen der Betriebsschaltfrequenz umfasst, die Schaltfrequenz des Schaltsignals abzustimmen, während der tatsächliche Gleichstromversorgungsstrom bestimmt wird, der der Gleichstromquelle entnommen wird, bis der tatsächliche Gleichstromversorgungsstrom in einem vorbestimmten Bereich liegt.

14. Kalibrierungsvorrichtung zum Kalibrieren einer induktiven Erwärmungsanordnung nach einem der Ansprüche 1 bis 11, insbesondere zur Verwendung in einem Verfahren nach Anspruch 12, wobei die Kalibrierungsvorrichtung eine Referenzsuszeptoranordnung umfasst, die induktiv mit dem Induktor der Erwärmungsanordnung koppelbar ist, und eine Kalibrierungssteuerung, der mit der Steuerung der Erwärmungsanordnung wirkverbindbar ist, wobei die Kalibrierungssteuerung ausgelegt ist, um das von der Steuerung der Erwärmungsanordnung übermittelte Stromsignal aufzunehmen, um in Reaktion auf das Stromsignal die Betriebsschaltfrequenz des Schaltsignals zu bestimmen, für die im Betrieb der von der Gleichstromquelle entnommene Gleichstromversorgungsstrom in dem vorbestimmten Bereich liegt, und um ein die bestimmte Betriebsschaltfrequenz anzeigendes Signal an die Steuerung der Erwärmungsanordnung zu übermitteln.

15. Kalibrierungsvorrichtung nach Anspruch 14, wobei die Kalibrierungssteuerung ausgelegt ist, um die Betriebsschaltfrequenz des Schaltsignals durch Berechnen einer Frequenzverschiebung unter Verwendung einer vorher bekannten Funktion zwischen dem Gleichstrom und der Schaltfrequenz zu bestimmen, die auf die Schaltfrequenz anzuwenden ist, bei der der dem empfangenen Stromsignals zugewiesene Gleichstromversorgungsstrom gemessen wurde.

## Revendications

1. Agencement de chauffage par induction pour le chauffage d'un substrat formant aérosol, dans lequel l'agencement de chauffage comprend une source d'alimentation CC et une électronique d'alimentation électrique comprenant un onduleur CC/CA raccordé à la source d'alimentation CC, dans lequel l'onduleur CC/CA comprend un amplificateur de puissance à commutation résonnante avec au moins un commutateur à transistor, au moins un circuit d'attaque de commutateur à transistor associé au commutateur à transistor et un réseau de charge LC comprenant au moins un condensateur et au moins une inductance, dans lequel l'inductance est configurée pour générer un champ magnétique alternatif pendant le fonctionnement de l'agencement de chauffage pour chauffer par induction le substrat formant aérosol, dans lequel le circuit d'attaque de commutateur de transistor comprend un oscillateur accordable configuré pour fournir en sortie un signal de commutation au commutateur à transistor ayant une fréquence de commutation accordable, dans lequel l'agencement de chauffage comprend en outre un capteur de courant pour déterminer le courant d'alimentation CC tiré depuis la source d'alimentation CC pendant le fonctionnement de l'agencement de chauffage, et un dispositif de commande configuré pour recevoir un signal de courant en provenance du capteur de courant indicatif du courant d'alimentation CC et pour accorder la fréquence de commutation du signal de commutation en réponse au signal de courant reçu afin d'accorder le courant d'alimentation CC tiré depuis la source d'alimentation CC pour être dans une plage prédéterminée.

2. Agencement de chauffage par induction selon la revendication 1, dans lequel la fréquence de commutation peut être accordée dans une plage de ± 20 pour cent, en particulier de ± 10 pour cent, de préférence de ± 5 pour cent autour d'une fréquence centrale.

3. Agencement de chauffage par induction selon l'une quelconque des revendications précédentes, dans lequel la fréquence de commutation peut être accordée dans une plage entre 5,4 MHz et 8 MHz, en particulier entre 6,0 MHz et 7,5 MHz, de préférence entre 6,4 MHz et 7,2 MHz.

4. Agencement de chauffage par induction selon l'une quelconque des revendications précédentes, dans lequel une tolérance d'une capacité du condensateur est dans une plage entre ± 2 pour cent et ± 4 pour cent d'une valeur de capacité nominale du condensateur.

5. Agencement de chauffage par induction selon l'une quelconque des revendications précédentes, dans lequel une tolérance d'une inductance de l'inductance est dans une plage entre ± 3 pour cent et ± 7 pour cent, en particulier entre ± 4 pour cent et ± 6 pour cent, de préférence de ± 5 pour cent d'une valeur d'inductance nominale de l'inductance.

6. Agencement de chauffage par induction selon l'une quelconque des revendications précédentes, dans lequel l'amplificateur de puissance à commutation est un amplificateur de puissance de classe C, un amplificateur de puissance de classe D et un amplificateur de puissance de classe E.

7. Agencement de chauffage par induction selon l'une quelconque des revendications précédentes, dans lequel le dispositif de commande est configuré pour régler l'oscillateur accordable pour fournir en sortie un signal de commutation ayant une fréquence de commutation de fonctionnement déterminée en réponse au signal de courant reçu, pour laquelle fréquence de commutation de fonctionnement le courant d'alimentation CC tiré depuis la source d'alimentation CC est dans la plage prédéterminée.

8. Agencement de chauffage par induction selon l'une quelconque des revendications précédentes, dans lequel le dispositif de commande peut être couplé de manière fonctionnelle à un appareil d'étalonnage configuré pour déterminer en réponse au signal de courant la fréquence de commutation de fonctionnement du signal de commutation pour lequel, en fonctionnement, le courant d'alimentation CC tiré depuis la source d'alimentation CC est dans la plage prédéterminée, dans lequel le dispositif de commande est configuré pour communiquer le signal de courant à l'appareil d'étalonnage et pour recevoir un signal communiqué depuis l'appareil d'étalonnage indiquant la fréquence de commutation de fonctionnement déterminée.

9. Agencement de chauffage par induction selon l'une quelconque des revendications 1 à 7, dans lequel le dispositif de commande est couplé de manière fonctionnelle au capteur de courant et au circuit d'attaque de commutateur à transistor dans une configuration de boucle de rétroaction.

10. Agencement de chauffage par induction selon la revendication 9, dans lequel le dispositif de commande est configuré pour déterminer, en particulier en réponse au signal de courant, la fréquence de commutation de fonctionnement du signal de commutation pour lequel, en fonctionnement, le courant d'alimentation CC tiré depuis la source d'alimentation CC est dans la plage prédéterminée.

11. Agencement de chauffage par induction selon l'une quelconque des revendications précédentes, comprenant en outre un agencement suscepteur, dans lequel l'agencement suscepteur est agencé au sein du champ magnétique alternatif généré par l'inductance pendant le fonctionnement de l'agencement de chauffage.

12. Procédé d'étalonnage d'un agencement de chauffage par induction selon l'une quelconque des revendications 1 à 11, le procédé comprenant :
- le couplage fonctionnel de l'agencement de chauffage à un agencement suscepteur de référence ;
- la mise en fonctionnement de l'agencement de chauffage pour chauffer l'agencement suscepteur de référence ;
- la détermination du courant d'alimentation CC réel tiré depuis la source d'alimentation CC pendant le fonctionnement de l'agencement de chauffage ;
- la détermination d'une fréquence de commutation de fonctionnement du signal de commutation pour lequel, en fonctionnement, le courant d'alimentation CC réel tiré depuis la source d'alimentation CC est dans la plage prédéterminée ;
- le réglage de l'oscillateur accordable pour fournir en sortie un signal de commutation ayant la fréquence de commutation de fonctionnement déterminée qui commute la fréquence.

13. Procédé selon la revendication 12, dans lequel la détermination de la fréquence de commutation de fonctionnement comprend l'accord de la fréquence de commutation du signal de commutation tout en déterminant le courant d'alimentation CC réel tiré depuis la source d'alimentation CC jusqu'à ce que le courant d'alimentation CC réel soit dans une plage prédéterminée.

14. Appareil d'étalonnage pour étalonner un agencement de chauffage par induction selon l'une quelconque des revendications 1 à 11, en particulier pour une utilisation dans un procédé selon la revendication 12, dans lequel l'appareil d'étalonnage comprend un agencement suscepteur de référence pouvant être couplé de manière inductive à l'inductance de l'agencement de chauffage et un dispositif de commande d'étalonnage pouvant être couplé de manière fonctionnelle au dispositif de commande de l'agencement de chauffage, dans lequel le dispositif de commande d'étalonnage est configuré pour recevoir le signal de courant communiqué depuis le dispositif de commande de l'agencement de chauffage, pour déterminer, en réponse au signal de courant, la fréquence de commutation de fonctionnement du signal de commutation pour lequel, en fonctionnement, le courant d'alimentation CC tiré depuis la source d'alimentation CC est dans la plage prédéterminée, et pour communiquer un signal indicatif de la fréquence de commutation de fonctionnement déterminée au dispositif de commande de l'agencement de chauffage.

15. Appareil d'étalonnage selon la revendication 14, dans lequel le dispositif de commande d'étalonnage est configuré pour déterminer la fréquence de commutation de fonctionnement du signal de commutation en calculant un décalage de fréquence à l'aide d'une fonction préalablement connue entre le courant CC et la fréquence de commutation à appliquer à la fréquence de commutation à laquelle le courant d'alimentation CC associé au signal de courant reçu a été mesuré.
